# EUROPEAN PATENT APPLICATION

(11) **EP 1 777 999 A1**
(43) Date of publication of application: **25.04.2007**
(21) Application number: 06021498.8
(22) Date of filing: 13.10.2006
(51) Int. Cl.: H05K 3/34

(54) **Circuit board providing coplanarity of solders and high soldering reliability for semiconductor component**

(30) Priority: 24.10.2005 JP 2005308493
(71) Applicant: ALPS ELECTRIC CO., LTD., Tokyo 145-8501 (JP)
(72) Inventor: Yatsu, Hiroyuki, Ota-ku Tokyo 145-8501 (JP); Takeda, Shuichi, Ota-ku Tokyo 145-8501 (JP)
(74) Representative: Klunker . Schmitt-Nilson . Hirsch

(57) **Abstract**

A circuit board according to the present invention is so formed that an extension pattern not covered with an insulating film is provided at a NC land that does not allow an electric signal to pass therethrough, so as to have a configuration equivalent to that of a pattern not covered with the insulating film and provided at a land that allows the electric signal to pass therethrough. Accordingly, the NC land may have an exposed surface area equivalent to that of the land. Therefore, when a semiconductor component is soldered using solders, bumps of the solders at the NC land and at the land may be evenly formed, thereby providing coplanarity of the solders, and increasing soldering reliability for the semiconductor component.

## Description

### BACKGROUND OF THE INVENTION

### 1. Field of the Invention

The present invention relates to a circuit board which is used for various electronic apparatuses, electronic circuit units, and the like, and is particularly suitable for attachment of a semiconductor component.

### 2. Description of the Related Art

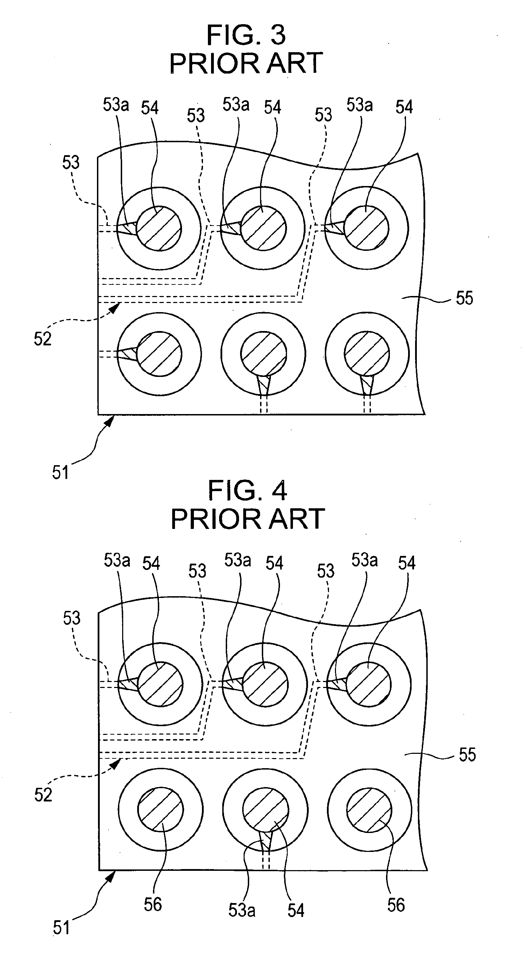

Describing a conventional circuit board used for attachment of a semiconductor component according to Fig. 3, an electrically conductive pattern 52 provided on an insulating substrate 51 includes a pattern 53 that allows an electric signal to pass therethrough, and a land 54 provided at an end of the pattern 53. An insulating film 55 is provided on the insulating substrate 51. The insulating film 55 covers the pattern 53 such that the land 54, and a vicinity 53a of the land 54 of the pattern 53 are exposed. Electrodes of the semiconductor component are soldered on the land 54 and the vicinity 53a which are not covered with the insulating film 55. Accordingly, the conventional circuit board is formed (for instance, see Japanese Unexamined Patent Application Publication No. 2001-68836).

As typically shown in Fig. 4, the electrically conductive pattern 52 of the conventional circuit board used for the attachment of the semiconductor component is composed of the land 54 which is connected to the pattern 53 that allows the electric signal to pass therethrough, and an electrically-non-connected NC land 56 having an area equivalent to that of the land 54. The NC land 56 is preparatorily provided for increasing soldering strength for the semiconductor component, or for increasing the number of semiconductor circuits in the future. Alternatively, the NC land 56 is formed as a remaining portion of a semiconductor circuit which is not currently used. In the conventional circuit board, the electrodes of the semiconductor component are soldered on the land 54 and the vicinity 53a not covered with the insulating film 55, and on the NC land 56 not covered with the insulating film 55.

However, in the conventional circuit board, since an exposed surface area of the NC land 56 not covered with the insulating film 55 is smaller than an exposed surface area of the land 54 including the vicinity 53a not covered with the insulating film 55, when the semiconductor component is soldered on the circuit board, a bump height of a solder becomes small at the land 54 including the vicinity 53a, while a bump height of a solder becomes large at the NC land 56. Due to this, not only coplanarity of the solders may not be provided, but also soldering reliability for the semiconductor component may decrease.

### SUMMARY OF THE INVENTION

To solve the above-described problems of the prior art, an object of the present invention is to provide a circuit board capable of providing the coplanarity of the solders and the high soldering reliability for the semiconductor component.

To attain the above-described object, a circuit board according to a first aspect of the present invention includes an insulating substrate that is provided with an electrically conductive pattern made of metal, in which the electrically conductive pattern includes a land having a surface that is not covered with an insulating film, a pattern that is connected to the land and allows an electric signal to pass therethrough, a NC land having a surface that is not covered with the insulating film, and an extension pattern that is connected to the NC land and does not allow the electric signal to path therethrough, and in which the pattern is covered with the insulating film such that a vicinity of the land is not covered with the insulating film, and the extension pattern is provided such that a vicinity of the NC land is not covered with the insulating film.

Preferably, in the circuit board according to a second aspect of the presnet invention, a surface area of the land may be substantially equivalent to that of the NC land.

Preferably, in the circuit board according to a third aspect of the presnet invention, an exposed surface area of the land and the vicinity of the pattern not covered with the insulating film may be substantially equivalent to that of the NC land and the vicinity of the extension pattern not covered with the insulating film.

Preferably, the circuit board according to a fourth aspect of the presnet invention may further include a semiconductor component that includes a plurality of electrodes, in which the electrodes may be soldered on the land and the vicinity of the pattern, and on the NC land and the vicinity of the extension pattern.

In the circuit board according to the present invention, the extension pattern not covered with the insulating film is provided at the NC land that does not allow the electric signal to pass therethrough, and the NC land has an equivalent arrangement as that of the pattern not covered with the insulating film of the land that allows the electric signal to pass therethrough. Accordingly, the exposed surface area of the NC land may be equivalent to that of the land. Therefore, when the semiconductor component is soldered, bumps of the solders at the NC land and at the land may be evenly formed, thereby providing coplanarity of the solders, and increasing soldering reliability for the semiconductor component.

In addition, since the surface area of the land is substantially equivalent to that of the NC land, the land may be easily formed, thereby providing the circuit board with good productivity.

In addition, since the exposed surface area of the land is substantially equivalent to that of the NC land, when the semiconductor component is soldered, the bumps of the solders at the NC land and at the land may be evenly formed, thereby providing the coplanarity of the solders, and further increasing the soldering reliability for the semiconductor component.

In addition, since the circuit includes the semiconductor component having the plurality of electrodes, and the electrodes are soldered on the land and the vicinity of the pattern, and on the NC land and the vicinity of the extension pattern, the bumps of the solders at the NC land and at the land may be evenly formed, thereby providing the coplanarity of the solders, and providing the circuit board with the semiconductor reliably soldered.

### BRIEF DESCRIPTION OF THE DRAWINGS

Fig. 1 is an enlarged cross sectional view showing a primary portion of a circuit board on which a semiconductor component is attached, according to an embodiment of the present invention;
Fig. 2 is a plan view showing a primary portion of the circuit board according to the embodiment of the present invention;
Fig. 3 is a plan view showing a primary portion of a conventional circuit board; and
Fig. 4 is a plan view showing a primary portion including a NC land, of the conventional circuit board.

### DESCRIPTION OF THE PREFERRED EMBODIMENTS

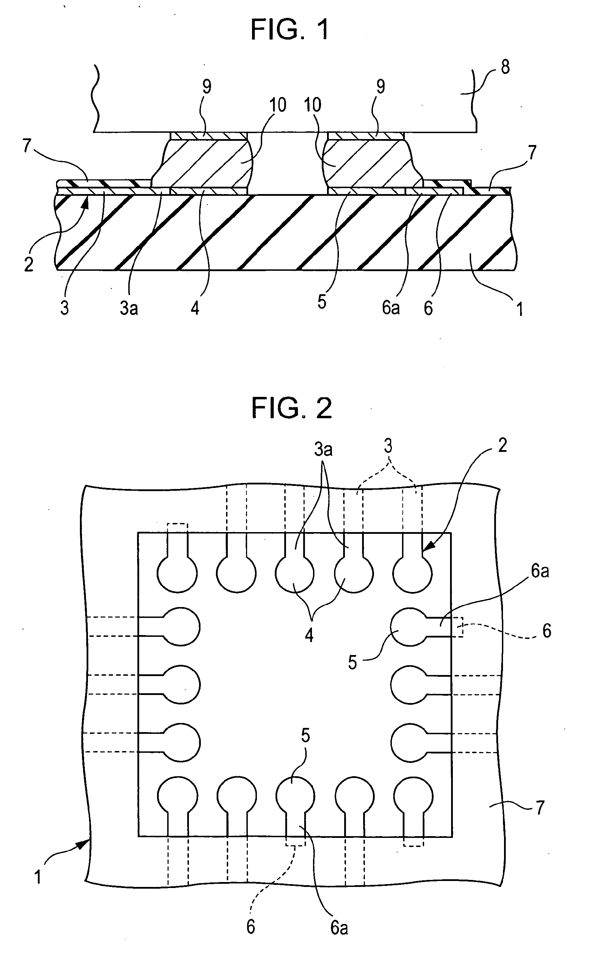

Describing an embodiment of the present invention with reference to the drawings, Fig. 1 is an enlarged cross sectional view showing a primary portion of a circuit board on which a semiconductor component is attached, according to the present invention, and Fig. 2 is a plan view showing a primary portion of the circuit board according to the present invention. Now, describing a configuration of the circuit board according to the present invention based on Figs. 1 and 2, an electrically conductive pattern 2 is provided on an insulating substrate 1 made of a ceramic or the like. The electrically conductive pattern 2 includes a pattern 3 that allows an electric signal to pass therethrough, a plurality of lands 4 provided at ends of the pattern 3, a plurality of electrically-non-connected NC lands 5, and an electrically-non-connected extension pattern 6 connected to each NC land 5. A surface area of the land 4 is equivalent to that of the NC land 5, and a pattern width of the pattern 3 is equivalent to that of the extension pattern 6.

The circuit board of the present invention is so formed that an insulating film 7 made of a resist is provided on the insulating substrate 1, and the insulating film 7 covers an upper surface of the insulating substrate 1 such that the land 4, a vicinity 3a of the pattern 3 located in the vicinity of the land 4, the NC land 5, and a vicinity 6a of the extension pattern 6 located in the vicinity of the NC land 5 are exposed. In the circuit board of the present invention having the above-described configuration, an exposed surface area of the land 4 including the vicinity 3a which are not covered with the insulating film 7 is substantially equivalent to that of the NC land 5 including the vicinity 6a which are not covered with the insulating film 7.

On this circuit board of the present invention, as shown in Fig. 1, a plurality of electrodes 9 of a rectangular semiconductor component 8 composed of a bare chip or the like are soldered on the land 4 including the vicinity 3a, and on the NC land 5 including the vicinity 6a, by using solders 10. At this time, since the exposed surface area of the land 4 including the vicinity 3a is equivalent to that of the NC land 5 including the vicinity 6a, bumps of the solders 10 may be evenly formed, thereby providing coplanarity of the solders 10 and increasing soldering reliability using the solders 10 for the semiconductor component. In general, the NC land 5 is preparatorily provided for increasing soldering strength of the semiconductor component 8, or for increasing the number of semiconductor circuits in the future. Alternatively, the NC land 5 is formed as a remaining portion of a semiconductor circuit which is not currently used.

## Claims

1. A circuit board comprising:
an insulating substrate that is provided with an electrically conductive pattern made of metal,
wherein the electrically conductive pattern includes:
a land having a surface that is not covered with an insulating film;
a pattern that is connected to the land and allows an electric signal to pass therethrough;
a NC land having a surface that is not covered with the insulating film; and
an extension pattern that is connected to the NC land and does not allow the electric signal to pass therethrough,
wherein the pattern is covered with the insulating film such that a vicinity of the land is not covered with the insulating film, and
the extension pattern is provided such that a vicinity of the NC land is not covered with the insulating film.

2. The circuit board according to Claim 1, wherein a surface area of the land is substantially equivalent to that of the NC land.

3. The circuit board according to Claim 1 or 2, wherein an exposed surface area of the land and the vicinity of the pattern not covered with the insulating film is substantially equivalent to that of the NC land and the vicinity of the extension pattern not covered with the insulating film.

4. The circuit board according to any of Claims 1 to 3 further comprising:
a semiconductor component that includes a plurality of electrodes,
wherein the electrodes are soldered on the land and the vicinity of the pattern, and on the NC land and the vicinity of the extension pattern.
